# EUROPEAN PATENT SPECIFICATION

(11) **EP 2 392 025 B1**
(45) Date of publication and mention of the grant of the patent: **04.09.2013**
(21) Application number: 10736199.0
(22) Date of filing: 14.01.2010
(51) Int. Cl.: H01L 21/00

(54) **PHOTOVOLTAIC DEVICE WITH IMPROVED CRYSTAL ORIENTATION**
PV-MODUL MIT VERBSSERTER KRISTALLAUSRICHTUNG
DISPOSITIF PHOTOVOLTAÏQUE À ORIENTATION CRISTALLINE AMÉLIORÉE

(30) Priority: 29.01.2009 US 148276 P
(43) Date of publication of application: 07.12.2011
(73) Proprietor: First Solar, Inc, Perrysburg, OH 43551 (US)
(72) Inventor: YANG, Yu, Perrysburg OH 43551 (US); PASHMAKOV, Boil, Troy MI 48085 (US); ZHAO, Zhibo, Novi MI 48377 (US)
(74) Representative: Roberts, Gwilym Vaughan
(86) International application number: PCT/US2010/021052
(87) International publication number: WO 2010/088059

(56) References cited:
- US-A- 6 137 048
- US-A1- 2005 009 228
- US-A1- 2007 111 367
- US-A1- 2009 014 055
- US-A1- 2009 014 055
- US-A1- 2009 272 437

## Description

### TECHNICAL FIELD

The present invention relates to photovoltaic devices and methods of production.

### BACKGROUND

Photovoltaic devices include semiconductor material deposited over a substrate, for example, with a first layer serving as a window layer and a second layer serving as an absorber layer. The semiconductor window layer can allow the penetration of solar radiation to the absorber layer, such as a cadmium telluride layer, which converts solar energy to electricity. Photovoltaic devices can also contain one or more transparent conductive oxide layers, which are also often conductors of electrical charge.
Document US 6137 04 8A describes CdTe photovoltaic devices.

### DESCRIPTION OF DRAWINGS

FIG. 1 is a schematic of a photovoltaic device having multiple layers.
FIG. 2 is a schematic of a photovoltaic device having multiple layers.
FIG. 3 is a schematic of a photovoltaic device having multiple layers.
FIG. 4 is a schematic of a photovoltaic device having multiple layers.
FIG. 5 depicts results of a microstructure analysis of photovoltaic devices having multiple layers.

### DETAILED DESCRIPTION

According to the present invention, there is provided a photovoltaic device according to claim 1, and a method of manufacturing a photovoltaic device, according to claim 6.

A photovoltaic device containing a cadmium telluride material having an improved crystal orientation can result in a photovoltaic device with improved carrier mobility and enhanced device performance.

A photovoltaic device includes a transparent conductive oxide layer adjacent to a substrate and layers of semiconductor material. The layers of semiconductor material include a bi-layer, which may include an n-type semiconductor window layer, and a p-type semiconductor absorber layer. The n-type window layer and the p-type absorber layer may be positioned in contact with one another to create an electric field. Photons can free electron-hole pairs upon making contact with the n-type window layer, sending electrons to the n side and holes to the p side. Electrons can flow back to the p side via an external current path. The resulting electron flow provides current which, combined with the resulting voltage from the electric field, creates power. The result is the conversion of photon energy into electric power.

The performance of the photovoltaic device can be enhanced by using a cadmium telluride layer with an improved orientation for the p-type absorber layer. The improved orientation of the cadmium telluride can result in larger grain size, the result of which is a higher carrier mobility.

The photovoltaic device can include a barrier layer positioned between the substrate and the transparent conductive oxide layer to prohibit the diffusion of sodium, which is common when using soda-lime glass substrates, and can learl to device degradation and delamination. This barrier layer can be part of a transparent conductive oxide stack. The device can include a top layer buffer adjacent to the transparent conductive oxide layer, which can also be part of the transparent conductive oxide stack. The devices includes a back contact adjacent to the semiconductor bi-layer. The device can include a back support adjacent to the back contact to protect the photovoltaic device from external elements.

A method of making a photovoltaic device includes depositing a semiconductor window layer adjacent to a transparent conductive oxide layer, and depositing a semiconductor absorber layer adjacent to the semiconductor window layer. To achieve enhanced performance, a cadmium telluride layer with improved crystal orientation is used for the semiconductor absorber layer. To prevent the diffusion of sodium, the method can include depositing a barrier layer between the transparent conductive oxide layer and the substrate to form a transparent conductive oxide stack. A top layer buffer may be deposited adjacent to the transparent conductive oxide layer to form a transparent conductive oxide stack. The method can include annealing the transparent conductive oxide stack. For example, the transparent conductive oxide stack may be heated at any suitable temperature range, for any suitable duration. The method includes depositing a back contact adjacent to the semiconductor absorber layer. The method can include depositing a back support adjacent to the back contact to protect the photovoltaic device from external elements.

A photovoltaic device includes a transparent conductive oxide layer adjacent to a substrate, a semiconductor bi-layer adjacent to the transparent conductive oxide layer, and a back contact adjacent to the semiconductor bi-layer. The semiconductor bi-layer includes a semiconductor absorber layer adjacent to a semiconductor window layer. The semiconductor absorber layer includes an oriented crystallized semiconductor absorber layer. The transparent conductive oxide layer can include a cadmium stannate, an indium-doped cadmium oxide, or a tin-doped indium oxide. The substrate can include a glass, which can include a soda-lime glass.

The photovoltaic device can include a barrier layer positioned between the substrate and the transparent conductive oxide layer. The barrier layer can include a silicon dioxide or a silicon nitride.

The photovoltaic device can include a top layer adjacent to the transparent conductive oxide layer. The photovoltaic device can include both a barrier layer positioned between the substrate and the transparent conductive oxide layer, and a top layer adjacent to the transparent conductive oxide layer. The top layer can include a zinc stannate or a tin oxide. The semiconductor window layer can include a cadmium sulfide.

The oriented crystallized semiconductor absorber layer of the photovoltaic device includes an oriented cadmium telluride layer. The oriented cadmium telluride layer has a preferred orientation. About 65%n to about 75% of the crystals of the oriented cadmium telluride layer have a preferred orientation relative to a deposition plane of the layer. The photovoltaic device can include a back support adjacent to the back contact.

A method for manufacturing a photovoltaic device includes depositing a semiconductor window layer adjacent to a transparent conductive oxide layer, and depositing an oriented semiconductor absorber layer adjacent to the semiconductor window layer.

The method can include depositing a top layer adjacent to the transparent conductive oxide layer, prior to depositing a semiconductor window layer. The transparent conductive oxide layer can include a cadmium stannate, an indium-doped cadmium oxide, or a tin-doped indium oxide. Depositing a semiconductor window layer adjacent to the transparent conductive oxide layer can include depositing a cadmium sulfide layer. Depositing a top layer adjacent to the transparent conductive oxide layer can include sputtering a zinc stannate or a tin oxide onto the transparent conductive oxide layer to form a transparent conductive oxide stack. The method can include annealing the transparent conductive oxide stack. Annealing the transparent conductive oxide stack can include heating the transparent conductive oxide stack under reduced pressure. Annealing the transparent conductive oxide stack can include heating the transparent conductive oxide stack at about 400 °C to about 800 °C, or at about 500 °C to about 700 °C. Annealing the transparent conductive oxide stack can include heating the transparent conductive oxide stack for about 10 to about 25 minutes, or for about 15 to about 20 minutes.

Depositing a semiconductor window layer adjacent to the transparent conductive oxide layer can include transporting a vapor. Depositing an oriented semiconductor absorber layer adjacent to the semiconductor window layer can include transporting a vapor. Depositing an oriented semiconductor absorber layer adjacent to the semiconductor window layer includes placing a cadmium telluride layer on a substrate. Depositing an oriented semiconductor absorber layer includes orienting a crystalline semiconductor absorber layer with preferred orientation. About 65% to about 75% of the crystals of the oriented semiconductor absorber layer have a preferred orientation relative to a deposition plane of the layer.

The method includes depositing a back contact adjacent to the oriented semiconductor absorber layer. The method can include positioning a back support adjacent to the back contact.

The method includes depositing the transparent conductive oxide layer adjacent to a substrate. The method can include depositing the transparent conductive oxide layer adjacent to a barrier layer, prior to depositing the transparent conductive oxide layer adjacent to a substrate. The method can include depositing a top layer adjacent to the transparent conductive oxide layer, prior to depositing a semiconductor window layer adjacent to a transparent conductive oxide layer. The method can include depositing the transparent conductive oxide layer adjacent to a barrier layer prior to depositing the transparent conductive oxide layer adjacent to a substrate, and depositing a top layer adjacent to the transparent conductive oxide layer to form a transparent conductive oxide stack, prior to depositing a semiconductor window layer adjacent to a transparent conductive oxide layer. The method can include annealing the transparent conductive oxide stack. Annealing the transparent conductive oxide stack can include heating the transparent conductive oxide stack under reduced pressure. Annealing the transparent conductive oxide stack can include heating the transparent conductive oxide stack at about 400 °C to about 800 °C, or at about 500 °C to about 700 °C. Annealing the transparent conductive oxide stack can include heating the transparent conductive oxide stack for about 10 to about 25 minutes, or for about 15 to about 20 minutes.

Depositing the transparent conductive oxide layer adjacent to a substrate can include placing a cadmium stannate, an indium-doped cadmium oxide, or a tin-doped indium oxide onto the substrate. Depositing a semiconductor window layer adjacent to a transparent conductive oxide layer can include placing a cadmium sulfide layer adjacent to the transparent conductive oxide layer. Depositing the transparent conductive oxide layer adjacent to the substrate can include sputtering the transparent conductive oxide layer onto a glass to form a layered structure. The method can include annealing the layered structure. Annealing the layered structure can include heating the layered structure under reduced pressure. Annealing the layered structure can include heating the layered structure at about 400 °C to about 800 °C, or at about 500 °C to about 700 °C. Annealing the layered structure can include heating the layered structure for about 10 to about 25 minutes, or for about 15 to about 20 minutes.

Depositing the transparent conductive oxide layer adjacent to a barrier layer can include sputtering the transparent conductive oxide layer onto a silicon dioxide layer, or a silicon nitride layer to form a transparent conductive oxide stack. The method can include annealing the transparent conductive oxide stack. Annealing the transparent conductive oxide stack can include heating the transparent conductive oxide stack under reduced pressure. Annealing the transparent conductive oxide stack can include heating the transparent conductive oxide stack at about 400 °C to about 800 °C, or at about 500 °C to about 700 °C. Annealing the transparent conductive oxide stack can include heating the transparent conductive oxide stack for about 10 to about 25 minutes, or for about 15 to about 20 minutes.

Depositing a top layer adjacent to the transparent conductive oxide layer can include sputtering a zinc stannate or a tin oxide onto the transparent conductive oxide layer to form a transparent conductive oxide stack. The method can include annealing the transparent conductive oxide stack. Annealing the transparent conductive oxide stack can include heating the transparent conductive oxide stack under reduced pressure. Annealing the transparent conductive oxide stack can include heating the transparent conductive oxide stack at about 400 °C to about 800 °C, or at about 500 °C to about 700 °C. Annealing the transparent conductive oxide stack can include heating the transparent conductive oxide stack for about 10 to about 25 minutes, or for about 15 to about 20 minutes.

Depositing a semiconductor window layer adjacent to a transparent conductive oxide layer can include transporting a vapor. Depositing an oriented semiconductor absorber layer adjacent to the semiconductor window layer can include transporting a vapor.

Depositing an oriented semiconductor absorber layer includes placing a cadmium telluride layer on a substrate. Depositing an oriented semiconductor absorber layer includes orienting a crystalline semiconductor absorber with preferred orientation. About 65% to about 75% of the crystals of the oriented semiconductor absorber layer have a preferred orientation relative to a deposition plane of the layer.

The method includes depositing a back contact adjacent to the oriented semiconductor absorber layer. The method can include depositing a back support adjacent to the back contact.

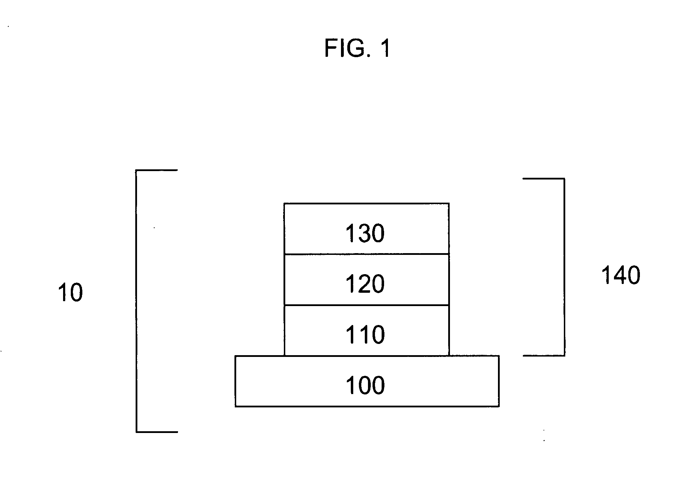

Referring to FIG. 1, a photovoltaic device 10 includes a transparent conductive oxide layer 120 deposited adjacent to a substrate 100. Transparent conductive oxide layer 120 is deposited on substrate 100. Transparent conductive oxide layer 120 can be deposited on an intermediate layer, such as barrier layer 110. Substrate 100 can include a glass, such as soda-lime glass. Transparent conductive oxide layer 120 can be deposited by sputtering, or by any known material deposition technique. Transparent conductive oxide layer 120 can include any suitable transparent conductive oxide material, including a cadmium stannate, an indium-doped cadmium oxide, or a tin-doped indium oxide.

In continuing reference to FIG. 1, barrier layer 110 can prevent sodium from diffusing from soda-lime glass substrate 100 into transparent conductive oxide layer 120. Barrier layer 110 can be deposited through any known deposition technique, including sputtering, and can include any suitable barrier material, including a silicon dioxide or a silicon nitride. A top layer, such as buffer layer 130 can be deposited adjacent to transparent conductive oxide layer 120. Buffer layer 130 can provide a surface onto which subsequent layers can be deposited, adjacent to transparent conductive oxide layer 120. Buffer layer 130 can be deposited through any known deposition technique, including sputtering and can include any suitable material, such as zinc stannate or a tin oxide. Transparent conductive oxide layer 120 can form transparent conductive oxide stack 140. Barrier layer 110 and buffer layer 130 can be part of transparent conductive oxide stack 140.

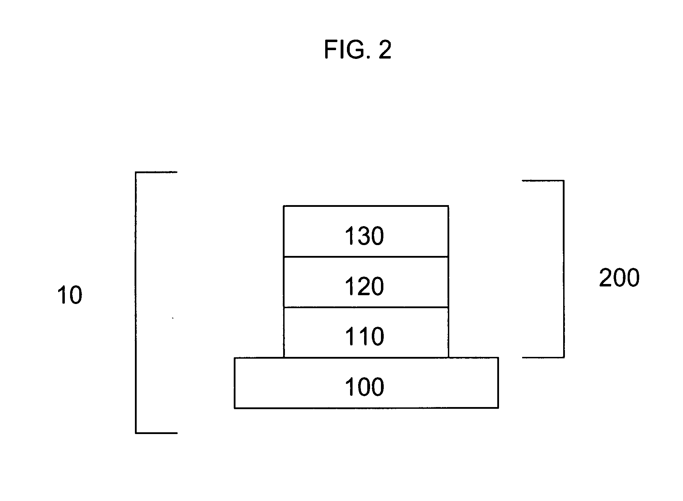

Referring to FIG. 1 and FIG. 2, transparent conductive oxide stack 140 from FIG. 1 can be annealed to form an annealed transparent conductive oxide stack 200. The annealing can occur under any suitable conditions. Transparent conductive oxide stack 140 can be annealed at any suitable pressure. Transparent conductive oxide stack 140 can be annealed under reduced pressure, a pressure less than atmospheric pressure, such as a substantial vacuum. Transparent conductive oxide stack 140 can be annealed at any suitable temperature or temperature range. For example, transparent conductive oxide stack 140 can be annealed at about 400 °C to about 800 °C. Transparent conductive oxide stack 140 can be annealed at about 500 °C to about 700 °C. The annealing can occur in the presence of a gas selected to control an aspect of the annealing. Transparent conductive oxide stack 140 can be annealed for any suitable duration. Transparent conductive oxide stack 140 can be annealed for about 10 to about 25 minutes. Transparent conductive oxide stack 140 can be annealed for about 15 to about 20 minutes. Annealing transparent conductive oxide stack 140 from FIG. 1 can provide annealed transparent conductive oxide stack 200 from FIG. 2.

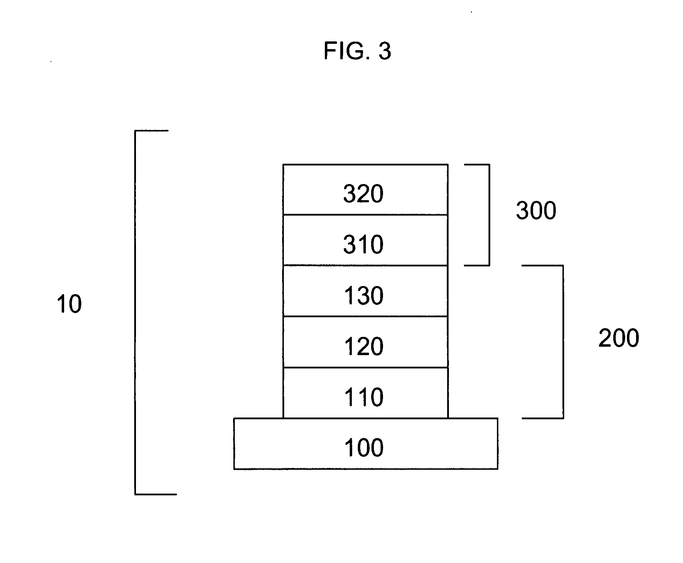

Referring to FIG. 3, semiconductor bi-layer 300 is formed adjacent to annealed transparent conductive oxide stack 200. Semiconductor bi-layer 300 can be formed on annealed transparent conductive oxide stack 200. Semiconductor bi-layer 300 includes semiconductor window layer 310 and oriented semiconductor absorber layer 320. Semiconductor window layer 310 of semiconductor bi-layer 300 can be deposited adjacent to annealed transparent conductive oxide stack 200. Semiconductor window layer 310 can include any suitable window material, such as cadmium sulfide, and can be formed by any suitable deposition method, such as vapor transport deposition. Oriented semiconductor absorber layer 320 is deposited adjacent to semiconductor window layer 310. Oriented semiconductor absorber layer 320 can be deposited on semiconductor window layer 310. Oriented semiconductor absorber layer 320 can be any suitable absorber material, such as cadmium telluride, and can be formed by any suitable method, such as vapor transport deposition.

Oriented semiconductor absorber layer 320 in photovoltaic device 10 can have an oriented crystalline microstructure including large grains. Oriented semiconductor absorber layer 320 has a preferred orientation. For example, a preferred orientation semiconductor absorber layer 320 can have a preferential orientation as opposed to a random orientation, such as an in-plane orientation, an orientation perpendicular to a deposition plane of the layer, or an orientation perpendicular to the growth plane. Oriented semiconductor absorber layer 320 can have a microstructure providing crystals of oriented semiconductor absorber layer to be oriented in a deposition plane of the layer. About 65% to about 75% of the crystals of oriented semiconductor absorber layer 320 have a preferred orientation relative to a deposition plane of the layer. The resulting crystal grains can be large. For example, the grains can have an average size of about 1.4 µm or greater. The grains can have an average size of about 1.8 µm or greater, for example 1.88 µm.

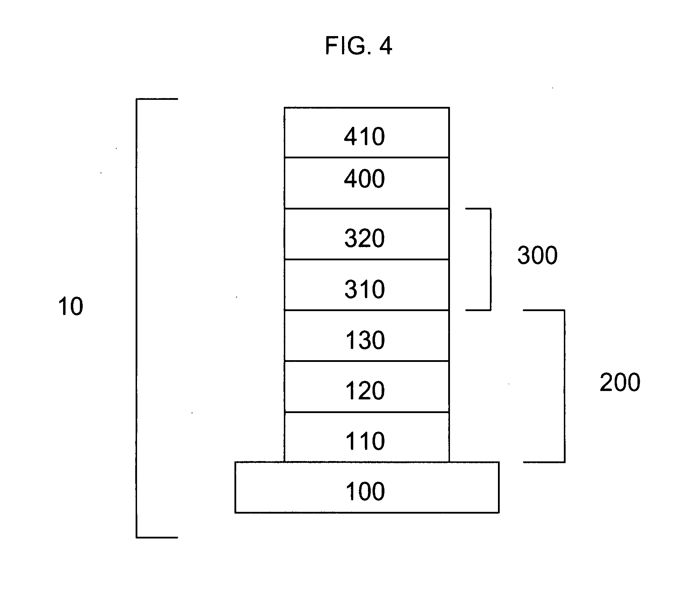

Referring to FIG. 4, a back contact 400 is deposited adjacent to oriented semiconductor absorber layer 320. Back contact 400 is deposited adjacent to semiconductor bi-layer 300. Back contact 400 can include any suitable material, including a metal. A back support 410 can be positioned adjacent to back contact 400.

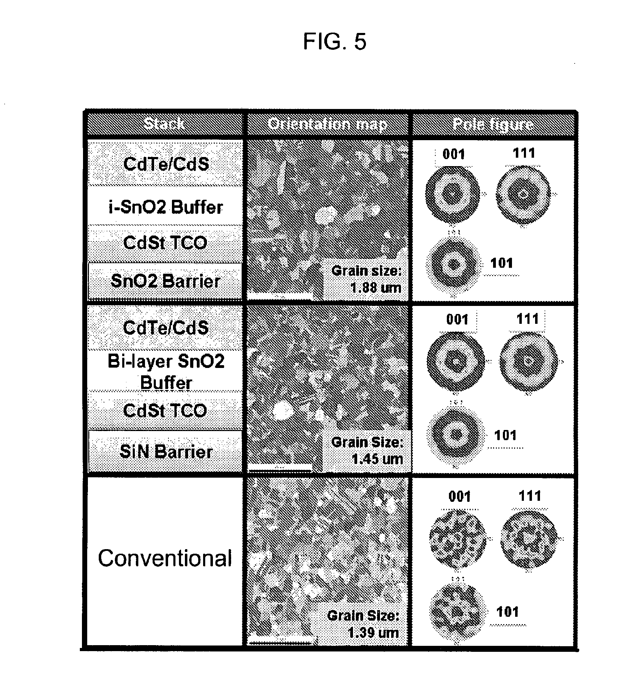

Referring to FIG. 5, two photovoltaic devices manufactured as described above were compared with a known photovoltaic device structure. The conventional device included a cadmium sulfide-cadmium telluride bi-layer formed on glass. The first experimental device included a transparent conductive oxide stack in accordance with the present invention, including a silicon nitride barrier layer, a cadmium stannate transparent conductive oxide layer, and a bi-layer tin oxide buffer layer. A cadmium sulfide-cadmium telluride bi-layer was formed on the transparent conductive oxide stack. The second experimental device included a transparent conductive oxide stack in accordance with the present invention, including a tin oxide barrier layer, a cadmium stannate transparent conductive oxide layer and a doped tin oxide buffer layer. A cadmium sulfide-cadmium telluride bi-layer was formed on the transparent conductive oxide stack.

In both experimental devices, the transparent conductive oxide stack was deposited by an in-line sputter system layer-by-layer at room temperature, and then annealed in a vacuum system at around 600 °C for about 17 minutes. The stacks were then coated with a cadmium sulfide window layer and a cadmium telluride layer absorber layer. The orientation maps of FIG. 5 show that the cadmium telluride crystals of the experimental devices had strong <111> orientation compared to those of the conventional sample, which were polycrystalline with random orientation. The orientation maps also indicate a larger grain size for the first and second experimental devices (1.88 µm and 1.45 µm respectively) than that for the conventional sample (1.39 µm). The pole figure maps of FIG. 5 show a strong orientation in the <111> direction for the experimental devices.

The embodiments described above are offered by way of illustration and example. It should be understood that the examples provided above may be altered in certain respects and still remain within the scope of the claims.

## Claims

1. A photovoltaic device (10), comprising:
a transparent conductive oxide layer (120) adjacent to a substrate (100);
a semiconductor bi-layer (300) adjacent to the transparent conductive oxide layer (120), the semiconductor bi-layer (300) comprising an oriented crystallized semiconductor absorber layer (320) adjacent to a semiconductor window layer (310), wherein the oriented crystallized semiconductor absorber layer (320)comprises an oriented crystallized cadmium telluride layer; and
a back contact (400) adjacent to the semiconductor bi-layer (300), **characterised in that** about 65% to about 75% of the crystals of the oriented cadmium telluride layer have a preferred orientation relative to a deposition plane of the oriented cadmium telluride layer.

2. The photovoltaic device of claim 1, wherein the transparent conductive oxide layer (120) comprises a cadmium stannate, or an indium-doped cadmium oxide, or a tin-doped indium oxide, or
wherein the substrate (100) comprises a glass, and optionally wherein the glass comprises a soda-lime glass.

3. The photovoltaic device of claim 1, further comprising a barrier layer (110) positioned between the substrate (100) and the transparent conductive oxide layer (120), and optionally wherein the barrier layer (110) comprises a silicon dioxide or a silicon nitride.

4. The photovoltaic device of claim 1 or claim 3, further comprising a top layer (130) adjacent to the transparent conductive oxide layer (120), and optionally wherein the top layer (130) comprises a zinc stannate or a tin oxide.

5. The photovoltaic device of claim 1, wherein the semiconductor window layer (310) comprises a cadmium sulfide, or
further comprising a back support (410) adjacent to the back contact (400).

6. A method for manufacturing a photovoltaic device (10), the method comprising:
depositing a transparent conductive oxide layer (120) adjacent to a substrate (100);
depositing a semiconductor window layer (310) adjacent to the transparent conductive oxide layer (120); and
depositing an oriented crystallized semiconductor absorber layer (320) adjacent to the semiconductor window layer (310), wherein the oriented crystallized semiconductor absorber layer comprises an oriented crystallized cadmium telluride layer, and wherein about 65% to about 75% of the crystals of the oriented cadmium telluride layer have a preferred orientation relative to a deposition plane of the oriented cadmium telluride layer; and
depositing a back contact (400) adjacent to the oriented semiconductor absorber layer (320).

7. The method of claim 6, further comprising depositing a top layer (130) adjacent to the transparent conductive oxide layer (120), prior to depositing the semiconductor window layer (310).

8. The method of claim 6, wherein the transparent conductive oxide layer (120) comprises a cadmium stannate or an indium-doped cadmium oxide or a tin-doped indium oxide, or
wherein depositing the semiconductor window layer (310) adjacent to the transparent conductive oxide layer (120) comprises placing a cadmium sulfide layer on the substrate or transporting a vapour.

9. The method of claim 7, wherein depositing the top layer (130) adjacent to the transparent conductive oxide layer (120) comprises sputtering a zinc stannate or a tin oxide onto the transparent conductive oxide layer (120) to form a transparent conductive oxide stack, and optionally further comprising annealing the transparent conductive oxide stack, and optionally wherein annealing the transparent conductive oxide stack comprises heating the transparent conductive oxide stack under reduced pressure, or at about 400°C to about 800°C, optionally at about 500°C to about 700°C, or for about 10 to about 25 minutes, and optionally for about 15 minutes to about 20 minutes.

10. The method of claim 6, wherein depositing the oriented crystallized semiconductor absorber layer (320) adjacent to the semiconductor window layer (310) comprises transporting a vapor, or placing a cadmium telluride layer on a substrate.

11. The method of claim 6, further comprising positioning a back support (410) adjacent to the back contact (400).

12. The method of claim 6, further comprising depositing the transparent conductive oxide layer (120) adjacent to a barrier layer (110), prior to placing the transparent conductive oxide layer (120) adjacent to the substrate (100).

13. The method of claim 6, further comprising depositing a top layer (130) adjacent to the transparent conductive oxide layer (120), prior to depositing the semiconductor window layer (310) adjacent to the transparent conductive oxide layer (120).

14. The method of claim 12, further comprising depositing a top layer (130) adjacent to the transparent conductive oxide layer (120) to form a transparent conductive oxide stack, prior to depositing the semiconductor window layer (310) adjacent to the transparent conductive oxide layer (120), and optionally further comprising annealing the transparent conductive oxide stack, and optionally wherein annealing the transparent conductive oxide stack comprises heating the transparent conductive oxide stack under reduced pressure, or at about 400°C to about 800°C, and optionally at about 500°C to about 700°C, or for about 10 to about 25 minutes, and optionally for about 15 minutes to about 20 minutes.

15. The method of claim 6, wherein depositing the transparent conductive oxide layer (120) adjacent to the substrate (100) comprises placing a cadmium stannate, an indium-doped cadmium oxide or a tin-doped indium oxide onto the substrate (100), or
wherein depositing the semiconductor window layer (310) adjacent to the transparent conductive oxide layer (120)comprises placing a cadmium sulfide layer adjacent to the transparent conductive oxide layer (120), or transporting a vapour, or
wherein depositing the transparent conductive oxide layer (120) adjacent to the substrate (100) comprises sputtering the transparent conductive oxide layer (120) onto a glass to form a layered structure, and optionally further comprising annealing the layered structure, and optionally wherein annealing the layered structure comprises heating the layered structure under reduced pressure, or at about 400°C to about 800°C, and optionally at about 500°C to about 700°C, or for about 10 to about 25 minutes, and optionally for about 15 minutes to about 20 minutes.

16. The method of claim 14, wherein depositing the transparent conductive oxide layer (120) adjacent to the barrier layer (110) comprises sputtering the transparent conductive oxide layer (120) onto a silicon dioxide layer or a silicon nitride layer to form a transparent conductive oxide stack, and optionally further comprising annealing the transparent conductive oxide stack, and optionally wherein annealing the transparent conductive oxide stack comprises heating the transparent conductive oxide stack under reduced pressure, or at about 400°C to about 800°C, and optionally at about 500°C to about 700°C, or for about 10 to about 25 minutes, and optionally for about 15 to about 20 minutes.

17. The method of claim 15, wherein depositing the top layer (130) adjacent to the transparent conductive oxide layer (120) comprises sputtering a zinc stannate or a tin oxide onto the transparent conductive oxide layer (120) to form a transparent conductive oxide stack, and optionally further comprising annealing the transparent conductive oxide stack, and optionally wherein annealing the transparent conductive oxide stack comprises heating the transparent conductive oxide stack under reduced pressure, or at about 400°C to about 800°C, and optionally at about 500°C to about 700°C, or for about 10 to about 25 minutes, and optionally for about 15 to about 20 minutes.

18. The method of claim 6, wherein depositing the oriented crystallized semiconductor absorber layer (320) adjacent to the semiconductor window layer (310) comprises transporting a vapor or placing a cadmium telluride layer on the substrate (100, or optionally further comprising depositing a back support (410) adjacent to the back contact (400).

## Patentansprüche

1. Photovoltaische Vorrichtung (10), aufweisend:
eine transparente leitende Oxidschicht (120) auf einem Substrat (100);
eine Halbleiterdoppelschicht (300) auf der transparenten leitenden Oxidschicht (120), wobei die Halbleiterdoppelschicht (300) eine orientierte, kristallisierte Halbleiterabsorptionsschicht (320) auf einer Halbleiterfensterschicht (310) aufweist, wobei die orientierte, kristallisierte Halbleiterabsorptionsschicht (320) eine orientierte, kristallisierte Kadmiumtelluridschicht aufweist; und
einen Rückkontakt (400) auf der Halbleiterdoppelschicht (300), **dadurch gekennzeichnet, dass** etwa 65% bis etwa 75% der Kristalle der orientierten Kadmiumtelluridschicht eine bevorzugte Orientierung relativ zu einer Abscheidungsebene der orientierten Kadmiumtelluridschicht haben.

2. Photovoltaische Vorrichtung nach Anspruch 1, wobei die transparente leitende Oxidschicht (120) ein Kadmiumstannat oder indiumdotiertes Kadmiumoxid oder ein zinndotiertes Indiumoxid aufweist oder
wobei das Substrat (100) ein Glas aufweist und wobei wahlweise das Glas ein Kalknatronglas aufweist.

3. Photovoltaische Vorrichtung nach Anspruch 1, des Weiteren aufweisend eine Sperrschicht (110), die zwischen dem Substrat (100) und der transparenten leitenden Oxidschicht (120) angeordnet ist, und wobei wahlweise die Sperrschicht (110) ein Siliziumdioxid oder ein Siliziumnitrid aufweist.

4. Photovoltaische Vorrichtung nach Anspruch 1 oder Anspruch 3, des Weiteren aufweisend eine obere Schicht (130) auf der transparenten leitenden Oxidschicht (120), und wobei wahlweise die obere Schicht (130) ein Zinkstannat oder ein Zinnoxid aufweist.

5. Photovoltaische Vorrichtung nach Anspruch 1, wobei die Halbleiterfensterschicht (310) ein Kadmiumsulfid aufweist oder
des Weiteren aufweisend eine Rückenstütze (410) auf dem Rückkontakt (400).

6. Verfahren zum Herstellen einer photovoltaischen Vorrichtung (10), wobei das Verfahren aufweist:
Abscheiden einer transparenten leitenden Oxidschicht (120) auf einem Substrat (100);
Abscheiden eine Halbleiterfensterschicht (310) auf der transparenten leitenden Oxidschicht (120); und
Abscheiden einer orientierten, kristallisierten Halbleiterabsorptionsschicht (320) auf der Halbleiterfensterschicht (310) wobei die orientierte, kristallisierte Halbleiterabsorptionsschicht (320) eine orientierte, kristallisierte Kadmiumtelluridschicht aufweist und wobei 65% bis etwa 75% der Kristalle der orientierten Kadmiumtelluridschicht eine bevorzugte Orientierung relativ zu einer Abscheidungsebene der orientierten Kadmiumtelluridschicht haben; und
Abscheiden eines Rückkontakts (400) auf der orientierten, kristallisierten Halbleiterabsorptionsschicht (320).

7. Verfahren nach Anspruch 6, des Weiteren aufweisend das Abscheiden einer oberen Schicht (130) auf der transparenten leitenden Oxidschicht (120) vor dem Abscheiden der Halbleiterfensterschicht (310).

8. Verfahren nach Anspruch 6, wobei die transparente leitende Oxidschicht (120) ein Kadmiumstannat oder indiumdotiertes Kadmiumoxid oder ein zinndotiertes Indiumoxid aufweist oder
wobei das Abscheiden der Halbleiterfensterschicht (310) auf der transparenten leitenden Oxidschicht (120) das Anordnen einer Kadmiumsulfidschicht auf dem Substrat oder das Transportieren eines Dampfes aufweist.

9. Verfahren nach Anspruch 7, wobei das Abscheiden der oberen Schicht (130) auf der transparenten leitenden Oxidschicht (120) das Sputtern eines Zinkstannats oder eines Zinnoxids auf die transparente leitende Oxidschicht (120) zur Bildung eines transparenten leitenden Oxidstapels aufweist, und des Weiteren wahlweise das Glühen des transparenten leitenden Oxidstapels aufweist, und wobei das Glühen des transparenten leitenden Oxidstapels wahlweise das Erwärmen des transparenten leitenden Oxidstapels unter vermindertem Druck oder bei etwa 400°C bis etwa 800°C, wahlweise bei etwa 500°C bis etwa 700°C oder über etwa 10 bis etwa 25 Minuten und wahlweise über etwa 15 Minuten bis etwa 20 Minuten aufweist.

10. Verfahren nach Anspruch 6, wobei das Abscheiden der orientierten, kristallisierten Halbleiterabsorptionsschicht (320) auf der Halbleiterfensterschicht (310) das Transportieren eines Dampfes oder das Anordnen einer Kadmiumtelluridschicht auf einem Substrat aufweist.

11. Verfahren nach Anspruch 6, des Weiteren aufweisend das Positionieren einer Rückenstütze (410) auf dem Rückkontakt (400).

12. Verfahren nach Anspruch 6, des Weiteren aufweisend das Abscheiden der transparenten leitenden Oxidschicht (120) auf einer Sperrschicht (110) vor dem Anordnen der transparenten leitenden Oxidschicht (120) auf dem Substrat (100).

13. Verfahren nach Anspruch 6, des Weiteren aufweisend das Abscheiden einer oberen Schicht (130) auf der transparenten leitenden Oxidschicht (120) vor dem Abscheiden der Halbleiterfensterschicht (310) auf der transparenten leitenden Oxidschicht (120).

14. Verfahren nach Anspruch 12, des Weiteren aufweisend das Abscheiden einer oberen Schicht (130) auf der transparenten leitenden Oxidschicht (120) zur Bildung eines transparenten leitenden Oxidstapels vor dem Abscheiden der Halbleiterfensterschicht (310) auf der transparenten leitenden Oxidschicht (120), und wahlweise des Weiteren aufweisend das Glühen des transparenten leitenden Oxidstapels, und wobei das Glühen des transparenten leitenden Oxidstapels wahlweise das Erwärmen des transparenten leitenden Oxidstapels unter vermindertem Druck oder bei etwa 400°C bis etwa 800°C, wahlweise bei etwa 500°C bis etwa 700°C oder über etwa 10 bis etwa 25 Minuten und wahlweise über etwa 15 Minuten bis etwa 20 Minuten aufweist.

15. Verfahren nach Anspruch 6, wobei das Abscheiden der transparenten leitenden Oxidschicht (120) auf dem Substrat (100) das Anordnen eines Kadmiumstannats oder indiumdotierten Kadmiumoxids oder eines zinndotierten Indiumoxids auf dem Substrat (100) aufweist oder
wobei das Abscheiden der Halbleiterfensterschicht (310) auf der transparenten leitenden Oxidschicht (120) das Anordnen einer Kadmiumsulfidschicht auf der transparenten leitenden Oxidschicht (120) oder das Transportieren eines Dampfes aufweist oder
wobei das Abscheiden der transparenten leitenden Oxidschicht (120) auf dem Substrat (100) das Sputtern der transparenten leitenden Oxidschicht (120) auf ein Glas zur Bildung einer schichtenförmigen Struktur aufweist, und des Weiteren wahlweise das Glühen der schichtenförmigen Struktur aufweist, und wobei wahlweise das Glühen der schichtenförmigen Struktur das Erwärmen der schichtenförmigen Struktur unter vermindertem Druck oder bei etwa 400°C bis etwa 800°C, wahlweise bei etwa 500°C bis etwa 700°C oder über etwa 10 bis etwa 25 Minuten und wahlweise über etwa 15 Minuten bis etwa 20 Minuten aufweist.

16. Verfahren nach Anspruch 14, wobei das Abscheiden der transparenten leitenden Oxidschicht (120) auf der Sperrschicht (110) das Sputtern der transparenten leitenden Oxidschicht (120) auf eine Siliziumdioxidschicht oder eine Siliziumnitridschicht zur Bildung eines transparenten leitenden Oxidstapels aufweist, und wahlweise des Weiteren das Glühen des transparenten leitenden Oxidstapels aufweist, und wobei das Glühen des transparenten leitenden Oxidstapels wahlweise das Erwärmen des transparenten leitenden Oxidstapels unter vermindertem Druck oder bei etwa 400°C bis etwa 800°C, wahlweise bei etwa 500°C bis etwa 700°C oder über etwa 10 bis etwa 25 Minuten und wahlweise über etwa 15 Minuten bis etwa 20 Minuten aufweist.

17. Verfahren nach Anspruch 15, wobei das Abscheiden der oberen Schicht (130) auf der transparenten leitenden Oxidschicht (120) das Sputtern eines Zinkstannats oder eines Zinnoxids auf die transparente leitende Oxidschicht (120) zur Bildung eines transparenten leitenden Oxidstapels aufweist, und des Weiteren wahlweise das Glühen des transparenten leitenden Oxidstapels aufweist, und wobei das Glühen des transparenten leitenden Oxidstapels wahlweise das Erwärmen des transparenten leitenden Oxidstapels unter vermindertem Druck oder bei etwa 400°C bis etwa 800°C, wahlweise bei etwa 500°C bis etwa 700°C oder über etwa 10 bis etwa 25 Minuten und wahlweise über etwa 15 Minuten bis etwa 20 Minuten aufweist.

18. Verfahren nach Anspruch 6, wobei das Abscheiden der orientierten, kristallisierten Halbleiterabsorptionsschicht (320) auf der Halbleiterfensterschicht (310) das Transportieren eines Dampfes oder das Anordnen einer Kadmiumtelluridschicht auf dem Substrat (100) aufweist oder des Weiteren wahlweise das Abscheiden einer Rückenstütze (410) auf dem Rückkontakt (400) aufweist.

## Revendications

1. Dispositif photovoltaïque (10), comprenant :
une couche d'oxyde conductrice transparente (120) adjacente à un substrat (100) ;
une bicouche semi-conductrice (300) adjacente à la couche d'oxyde conductrice transparente (120), la bicouche semi-conductrice (300) comprenant une couche d'absorption semi-conductrice cristallisée orientée (320) adjacente à une couche de fenêtre semi-conductrice (310), dans lequel la couche d'absorption semi-conductrice cristallisée orientée (320)comprend une couche de tellurure de cadmium cristallisée orientée ; et
un contact arrière (400) adjacent à la bicouche semi-conductrice (300), **caractérisé en ce qu'**environ 65 % à environ 75 % des cristaux de la couche de tellurure de cadmium orientée ont une orientation préférée par rapport à un plan de dépôt de la couche de tellurure de cadmium orientée.

2. Dispositif photovoltaïque selon la revendication 1, dans lequel la couche d'oxyde conductrice transparente (120) comprend un stannate de cadmium, ou un oxyde de cadmium dopé à l'indium, ou un oxyde d'indium dopé à l'étain, ou
dans lequel le substrat (100) comprend un verre, et éventuellement dans lequel le verre comprend un verre sodo-calcique.

3. Dispositif photovoltaïque selon la revendication 1, comprenant en outre une couche barrière (110) positionnée entre le substrat (100) et la couche d'oxyde conductrice transparente (120), et éventuellement dans lequel la couche barrière (110) comprend un dioxyde de silicium ou un nitrure de silicium.

4. Dispositif photovoltaïque selon la revendication 1 ou la revendication 3, comprenant en outre une couche supérieure (130) adjacente à la couche d'oxyde conductrice transparente (120), et éventuellement dans lequel la couche supérieure (130) comprend un stannate de zinc ou un oxyde d'étain.

5. Dispositif photovoltaïque selon la revendication 1, dans lequel la couche de fenêtre semi-conductrice (310) comprend un sulfure de cadmium, ou
comprenant en outre un support arrière (410) adjacent au contact arrière (400).

6. Procédé de fabrication d'un dispositif photovoltaïque (10), le procédé comprenant : le dépôt d'une couche d'oxyde conductrice transparente (120) adjacente à un substrat (100) ;
le dépôt d'une couche de fenêtre semi-conductrice (310) adjacente à la couche d'oxyde conductrice transparente (120) ; et
le dépôt d'une couche d'absorption semi-conductrice cristallisée orientée (320) adjacente à la couche de fenêtre semi-conductrice (310), dans lequel la couche d'absorption semi-conductrice cristallisée orientée comprend une couche de tellurure de cadmium cristallisée orientée, et dans lequel environ 65 % à environ 75 % des cristaux de la couche de tellurure de cadmium orientée ont une orientation préférée par rapport à un plan de dépôt de la couche de tellurure de cadmium orientée ; et
le dépôt d'un contact arrière (400) adjacent à la couche d'absorption semi-conductrice orientée (320).

7. Procédé selon la revendication 6, comprenant en outre le dépôt d'une couche supérieure (130) adjacente à la couche d'oxyde conductrice transparente (120), avant de déposer la couche de fenêtre semi-conductrice (310).

8. Procédé selon la revendication 6, dans lequel la couche d'oxyde conductrice transparente (120) comprend un stannate de cadmium, ou un oxyde de cadmium dopé à l'indium, ou un oxyde d'indium dopé à l'étain, ou
dans lequel le dépôt de la couche de fenêtre semi-conductrice (310) adjacente à la couche d'oxyde conductrice transparente (120) comprend la mise en place d'une couche de sulfure de cadmium sur le substrat ou le transport d'une vapeur.

9. Procédé selon la revendication 7, dans lequel le dépôt de la couche supérieure (130) adjacente à la couche d'oxyde conductrice transparente (120) comprend la projection d'un stannate de zinc ou d'un oxyde d'étain sur la couche d'oxyde conductrice transparente (120) pour former un empilement d'oxyde conducteur transparent, et comprenant éventuellement en outre un recuit de l'empilement d'oxyde conducteur transparent, et éventuellement dans lequel le recuit de l'empilement d'oxyde conducteur transparent comprend un chauffage de l'empilement d'oxyde conducteur transparent sous pression réduite, ou à environ 400 °C à environ 800 °C, éventuellement à environ 500 °C à environ 700 °C, ou pendant environ 10 à environ 25 minutes, et éventuellement pendant environ 15 minutes à environ 20 minutes.

10. Procédé selon la revendication 6, dans lequel le dépôt de la couche d'absorption semi-conductrice cristallisée orientée (320) adjacente à la couche de fenêtre semi-conductrice (310) comprend le transport d'une vapeur, ou la mise en place d'une couche de tellurure de cadmium sur un substrat.

11. Procédé selon la revendication 6, comprenant en outre le positionnement d'un support arrière (410) adjacent au contact arrière (400).

12. Procédé selon la revendication 6, comprenant en outre le dépôt de la couche d'oxyde conductrice transparente (120) adjacente à une couche barrière (110), avant mise en place de la couche d'oxyde conductrice transparente (120) adjacente au substrat (100).

13. Procédé selon la revendication 6, comprenant en outre le dépôt d'une couche supérieure (130) adjacente à la couche d'oxyde conductrice transparente (120), avant dépôt de la couche de fenêtre semi-conductrice (310) adjacente à la couche d'oxyde conductrice transparente (120).

14. Procédé selon la revendication 12, comprenant en outre le dépôt d'une couche supérieure (130) adjacente à la couche d'oxyde conductrice transparente (120) pour former un empilement d'oxyde conducteur transparent, avant dépôt de la couche de fenêtre semi-conductrice (310) adjacente à la couche d'oxyde conductrice transparente (120), et comprenant éventuellement en outre un recuit de l'empilement d'oxyde conducteur transparent, et éventuellement dans lequel le recuit de l'empilement d'oxyde conducteur transparent comprend un chauffage de l'empilement d'oxyde conducteur transparent sous pression réduite, ou à environ 400 °C à environ 800 °C, et éventuellement à environ 500 °C à environ 700 °C, ou pendant environ 10 à environ 25 minutes, et éventuellement pendant environ 15 minutes à environ 20 minutes.

15. Procédé selon la revendication 6, dans lequel le dépôt de la couche d'oxyde conductrice transparente (120) adjacente au substrat (100) comprend la mise en place d'un stannate de cadmium, d'un oxyde de cadmium dopé à l'indium ou d'un oxyde d'indium dopé à l'étain sur le substrat (100), ou
dans lequel le dépôt de la couche de fenêtre semi-conductrice (310) adjacente à la couche d'oxyde conductrice transparente (120) comprend la mise en place d'une couche de sulfure de cadmium adjacente à la couche d'oxyde conductrice transparente (120), ou le transport d'une vapeur, ou
dans lequel le dépôt de la couche d'oxyde conductrice transparente (120) adjacente au substrat (100) comprend une projection de la couche d'oxyde conductrice transparente (120) sur un verre pour former une structure en couche, et comprenant éventuellement en outre un recuit de la structure en couche, et éventuellement dans lequel le recuit de la structure en couche comprend un chauffage de la structure en couche sous pression réduite, ou à environ 400 °C à environ 800 °C, et éventuellement à environ 500 °C à environ 700 °C, ou pendant environ 10 à environ 25 minutes, et éventuellement pendant environ 15 minutes à environ 20 minutes.

16. Procédé selon la revendication 14, dans lequel le déposer de la couche d'oxyde conductrice transparente (120) adjacente à la couche barrière (110) comprend une projection de la couche d'oxyde conductrice transparente (120) sur une couche de dioxyde de silicium ou une couche de nitrure de silicium pour former un empilement d'oxyde conducteur transparent, et comprenant éventuellement en outre un recuit de l'empilement d'oxyde conducteur transparent, et éventuellement dans lequel le recuit de l'empilement d'oxyde conducteur transparent comprend un chauffage de l'empilement d'oxyde conducteur transparent sous pression réduite, ou à environ 400 °C à environ 800 °C, éventuellement à environ 500 °C à environ 700 °C, ou pendant environ 10 à environ 25 minutes, et éventuellement pendant environ 15 à environ 20 minutes.

17. Procédé selon la revendication 15, dans lequel le dépôt de la couche supérieure (130) adjacente à la couche d'oxyde conductrice transparente (120) comprend la projection d'un stannate de zinc ou d'un oxyde d'étain sur la couche d'oxyde conductrice transparente (120) pour former un empilement d'oxyde conducteur transparent, et comprenant éventuellement en outre un recuit de l'empilement d'oxyde conducteur transparent, et éventuellement dans lequel le recuit de l'empilement d'oxyde conducteur transparent comprend un chauffage de l'empilement d'oxyde conducteur transparent sous pression réduite, ou à environ 400 °C à environ 800 °C, éventuellement à environ 500 °C à environ 700 °C, ou pendant environ 10 à environ25 minutes, et éventuellement pendant environ 15 à environ 20 minutes.

18. Procédé selon la revendication 6, dans lequel le dépôt de la couche d'absorption semi-conductrice cristallisée orientée (320) adjacente à la couche de fenêtre semi-conductrice (310) comprend le transport d'une vapeur ou la mise en place d'une couche de tellurure de cadmium sur le substrat (100, ou comprenant éventuellement en outre le dépôt d'un support arrière (410) adjacent au contact arrière (400).
